# EUROPEAN PATENT SPECIFICATION

(11) **EP 2 584 598 B1**
(45) Date of publication and mention of the grant of the patent: **05.12.2018**
(21) Application number: 11185999.7
(22) Date of filing: 20.10.2011
(51) Int. Cl.: H01L 21/768, H01L 23/48, H01L 25/065

(54) **Method of producing a semiconductor device comprising a through-substrate via and a capping layer and corresponding semiconductor device**
Verfahren zur Herstellung eines Halbleiterbauelements mit einer Durchkontaktierung und einer Deckschicht und entsprechendes Halbleiterbauelement
Procédé de production d'un dispositif à semi-conducteur comprenant une connexion verticale et une couche d'encapsulage et dispositif à semi-conducteur correspondant

(43) Date of publication of application: 24.04.2013
(73) Proprietor: ams AG, 8141 Premstätten (AT)
(72) Inventor: Schrank, Franz, 8052 Graz (AT); Cassidy, Cathal, 8010 Graz (AT)
(74) Representative: Epping - Hermann - Fischer

(56) References cited:
- EP-A2- 2 408 006
- WO-A1-2011/125935
- JP-A- 2005 294 320
- JP-A- 2009 094 230
- US-A1- 2004 155 354
- US-A1- 2009 189 256
- US-A1- 2010 289 155
- US-A1- 2011 074 040

## Description

The invention relates to a semiconductor device having an unfilled through-substrate via or interconnect.

In threedimensional integration of semiconductor devices, semiconductor substrates that are provided with structures of integrated circuits, like conductor tracks and electronic circuit components, are stacked and bonded. The conductors that are arranged on different substrates may be connected by through-substrate vias, which are interconnects leading through a substrate. In the case of a silicon substrate these vias are usually designated as through-silicon vias. The via hole in the substrate may be filled with the electrically conductive material or with electrically conductive material and an additional dielectric material.

WO 2010/081603 A1 describes a through-substrate via comprising an unfilled hole in the semiconductor substrate. If the via hole is not completely filled, time and material are spared and the thermomechanical reliability of the device is improved. In a final stage of the manufacturing process, assembling or mounting steps may entail an application of underfill material or the like, which may become harmful and cause malfunction of the device if it enters the remaining opening of the through-substrate via.

US 2010/0190338 A1 describes a through-substrate via comprising a via hole that is filled with dielectric material.

US 7,932,608 B2 describes a production method for a semiconductor device having a through-silicon via, in which a photoresist or another suitable material is applied on a passivation layer to form a patterned mask, which covers the opening of the through-silicon via. The mask is used to etch at least one opening in the passiviation layer and is subsequently removed. The opening of the through-silicon via is filled with electrically conductive material.

US 2004/0155354 A1 discloses a semiconductor device having a chip with a through hole, in which a conductive layer is arranged forming a conductive via through the chip. A photosensitive solder resist layer is formed on the entire surface of the semiconductor chip to produce a permanent cover of the via hole.

JP 2009-094230 A discloses a semiconductor device having a substrate with a through hole, in which a conductive layer is arranged forming a conductive via through the substrate. A gap is left in the through hole, and the gap is closed by a protection layer.

US 2009/0189256 A1 discloses a semiconductor device having a substrate with a through hole, in which a conductive contact electrode layer is arranged forming a conductive via through the substrate. A stacked arrangement of semiconductor devices is made by inserting stacked bump electrodes formed on a semiconductor chip into through electrodes formed in the chip. A ring-shaped insulating film is arranged in a trench around the through hole at a specified distance, reaching from the front surface of the substrate to the rear surface.

It is an object of this invention to disclose a new semiconductor device with a through-substrate via comprising a void and a new method of producing such a semiconductor device.

This object is achieved with the method of producing a semiconductor device according to claim 1 and with the semiconductor device according to claim 4, respectively. Embodiments and alterations derive from the dependent claims.

The method of producing a semiconductor device comprises the steps of providing a semiconductor substrate with an electrically conductive structure, forming a hole through the substrate in a direction normal to its main surface, and forming a through-substrate via in the hole by introducing an electrically conductive material without filling the hole. A capping layer is applied above the main surface. The capping layer may be applied to close the opening of the remaining inner volume of the through-substrate via without filling the hole. Instead or additionally, an annular cavity may be formed surrounding the hole, and the capping layer may be applied to cover the annular cavity at least partially. The capping layer thus forms a permanent cover or a permanent partial cover. The capping layer is structured, so that the electrically conductive structure is not completely covered by the capping layer. The electrically conductive structure is therefore accessible for the application of an external electric connection.

The capping layer may be a dry film formed from a polyimide or a resist like a photoresist, for instance. The open volume that is closed by the capping layer may be filled with a gas, particularly with ambient air.

In an embodiment the capping layer is applied above the entire main surface of the substrate except for areas that are provided for an external electric connection or for a sawing street.

In a further embodiment the electrically conductive structure is provided with a conductor layer that has a contact area above the main surface. A covering layer is applied above the main surface and above the conductor layer, and the contact area is uncovered from the covering layer before the capping layer is applied.

In further embodiments, a further substrate is provided with a further electrically conductive structure and bonded to the first substrate in such a manner that the capping layer is arranged between said substrate and the further substrate. The electrically conductive structure of the substrate is electrically connected to the further electrically conductive structure of the further substrate.

In a further embodiment the through-substrate via is electrically connected to the further electrically conductive structure of the further substrate.

An annular cavity is formed surrounding the hole, and the capping layer is applied to the annular cavity. Thus the annular cavity may be closed with the capping layer.

In a further embodiment comprising an annular cavity surrounding the hole, the capping layer is removed from the hole, the through-substrate via is formed, and a further capping layer covering the inner volume of the through-substrate via is applied above the main surface.

In a further embodiment the capping layer is partially removed from the annular cavity, thus forming at least one bridge across the annular cavity.

In one aspect the semiconductor device comprises a semiconductor substrate with a main surface and an electrically conductive through-substrate via in a direction normal to the main surface. A capping layer is present above the main surface and closes an inner volume of the through-substrate via without filling it, thus forming a cover of the through-substrate via.

An annular cavity surrounds the through-substrate via, and a capping layer above the main surface at least partially covers the annular cavity.

The capping layer may particularly be a dry film formed from a polyimide or a resist like a photoresist, for instance. An embodiment of the semiconductor device further comprises an electrically conductive structure above the main surface. The capping layer is structured in such a manner that the electrically conductive structure is not completely covered by the capping layer.

Further embodiments comprise a further substrate with a further electrically conductive structure. The substrate and the further substrate are stacked with the capping layer arranged between them. The electrically conductive structure of the substrate is electrically connected to the further electrically conductive structure of the further substrate. In further embodiments the inner volume of the through-substrate via is filled with air.

In an embodiment of the semiconductor device comprising an annular cavity, the capping layer closes the annular cavity. In a further embodiment of the semiconductor device comprising an annular cavity, the capping layer forms at least one bridge across the annular cavity.

The following is a detailed description of exemplary embodiments of the invention and its advantages in conjunction with the accompanying drawings.
Figure 1 shows a section of a cross-section of a semiconductor device.
Figure 2 shows a section of a cross-section of an intermediate product of a method of production before the capping layer is structured.
Figure 3 shows a section of a cross-section according to Figure 2 after the capping layer has been structured.
Figure 4 shows a section of a cross-section according to Figure 3 after dicing and bonding steps.
Figure 5 shows a plan view of an area around the via hole of an embodiment.
Figure 6 shows a plan view of an area around the via hole of a further embodiment.
Figure 7 shows a section of a cross-section of an intermediate product of a further method of production before the capping layer is structured.
Figure 8 shows a detail of the cross-section according to Figure 7 after the application of support layers.
Figure 9 shows a detail of a cross-section of an intermediate product of a further method of production using a non-conformal oxide deposition to close the cavity.
Figure 10 shows a section of a cross-section of an intermediate product of a further method of production before the capping layer is structured.
Figure 11 shows a cross-section according to Figure 10 after the application of a blanket layer.
Figure 12 shows a cross-section according to Figure 11 after CMP and the application of a further blanket layer.
Figure 13 shows a cross-section according to Figure 12 after the structuring of the further blanket layer.

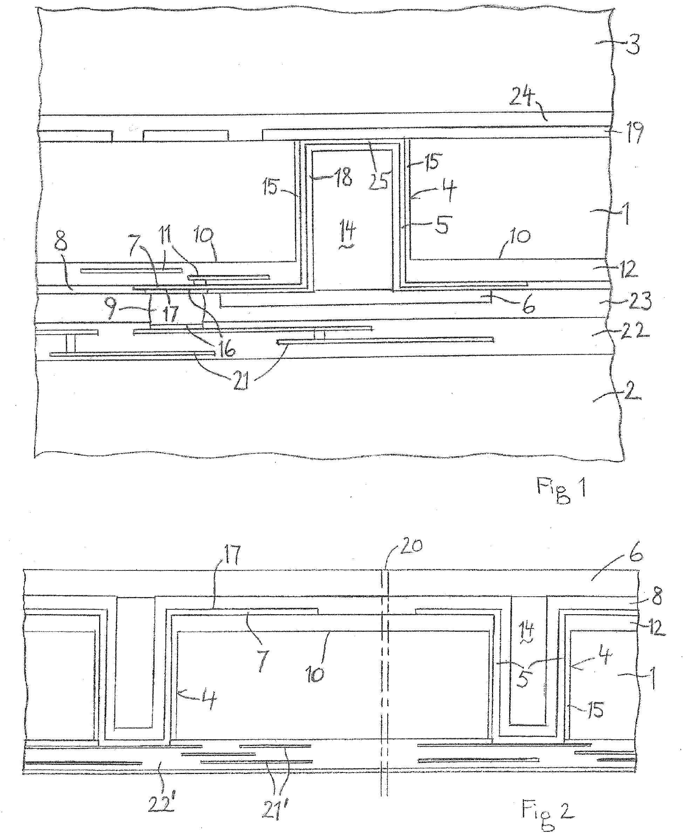

Figure 1 shows a section of a cross-section of a semiconductor device comprising a semiconductor substrate 1, which may be a silicon substrate, for instance. The substrate 1 is intended for a threedimensional integration with one or more further substrates. In the embodiment according to Figure 1, the substrate 1 is arranged between a first further substrate 2 and a second further substrate 3 forming a threedimensional integrated circuit. The substrate 1 is provided with an electrically conductive structure 11, which is arranged above a main surface 10 and may comprise structured metal layers embedded in an intermetal dielectric 12 as in a conventional wiring, for example. The substrate 2 is provided in a similar way with a further electrically conductive structure 21, which may be embedded in a further intermetal dielectric 22. The electrically conductive structure 11 of the substrate 1 may particularly comprise a conductor layer 7 having a contact area 17 that faces the further electrically conductive structure 21 of the further substrate 2.

A hole 4 is formed in the substrate 1 in a direction normal to the main surface 10. A through-substrate via 5 is formed in the hole 4 by an electrically conductive material like a metal. The electrically conductive material of the through-substrate via 5 may be insulated from the semiconductor material of the substrate 1 by a sidewall insulation 15 formed by dielectric material, which may be an oxide of the semiconductor material, for example.

The inner volume 14 of the hole 4 is left free from electrically conductive and dielectric materials that are provided for the through-substrate via 5. This inner volume 14 may be filled with a gas, particularly with air, and is closed by a capping layer 6, which is applied as a cover layer and is not introduced into the inner volume 14. Suitable materials for the capping layer 6 are a polyimide or a resist, particularly a photosensitive resist, but other materials may be used instead. The capping layer 6 is preferably a dry film and may be laminated.

In the device according to Figure 1, the conductor layer 7 is connected with the through-substrate via 5. A covering layer 8 of dielectric material is applied above the electrically conductive structure 11 and may also be provided as a passivation 18 of the through-substrate via 5. The covering layer 8 is removed from the contact area 17, which is connected with the further electrically conductive structure 21 of the further substrate 2 by means of contact pads 16 and an interconnect 9. This arrangement shows by way of an example how the through-substrate via 5 can be used to form the wiring of a threedimensionally integrated circuit. The structure of the conductor layers and interconnects may be changed according to the requirements of individual embodiments.

The interspace between the substrate 1 and the further substrate 2 may be filled with an underfill 23. The capping layer 6 prevents the underfill material from entering the inner volume 14 of the through-substrate via 5 and thus protects the through-substrate via 5. With the capping layer 6 there is no need to fill the through-substrate via 5 completely with solid material.

In the exemplary device according to Figure 1, a second further substrate 3 is arranged on the substrate 1 opposite to the first further substrate 2. The substrate 3 may comprise any semiconductor device that is suitable to be used together with the device of the first substrate 1. In the embodiment according to Figure 1 the second further substrate 3 comprises a structured layer 19. The interspace between the substrate 1 and the second further substrate 3 is filled with a further underfill 24. The second further substrate 3 may be a scintillator device and the structured layer 19 may be a sensor layer, for example. The through-substrate via 5 is electrically connected with the structured layer 19 in such a manner that the inner volume 14 is closed towards the second further substrate 3 by the contacting portion 25 of the through-substrate via 5. The capping layer 6 is therefore sufficient for a complete sealing of the inner volume 14.

Figure 2 shows a section of a cross-section of an intermediate product of the manufacturing process for the semiconductor device. The elements that are similar to elements represented in Figure 1 are designated with the same reference numerals. The substrate is used for the production of a plurality of devices, which are later separated in a dicing process along sawing streets 20. After the formation of the electrically conductive structures 11 in the upper intermetal dielectric 12 at the main surface 10 and the connection with further electrically conductive structures 21' in a further intermetal dielectric 22' on the rear side by through-substrate vias 5, the open inner volumes 14 of the through-substrate vias 5 are covered and closed with the capping layer 6. The inner volumes 14 may be or remain filled with a gas or may be evacuated. The capping layer 6 is preferably applied as a plane layer and may also be used to plararize the upper surface on which the capping layer 6 is applied. The capping layer 6 is preferably a material that is commonly used in semiconductor technology, like a polyimide or a photoresist.

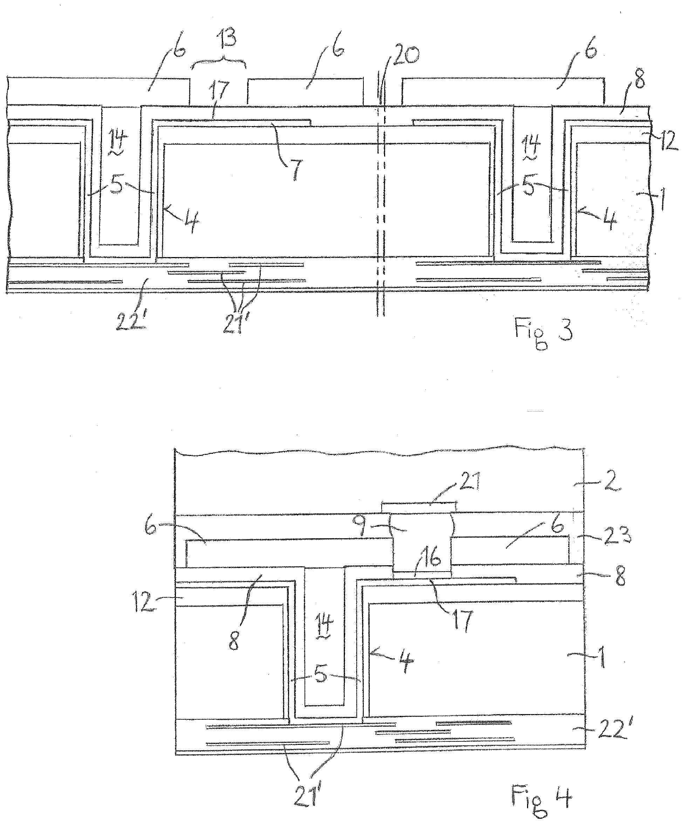

Figure 3 shows a section of a cross-section according to Figure 2 after the capping layer 6 has been structured to uncover areas 13 that are provided for an external electric connection or for sawing streets 20. In the areas 13 that are provided for an external electric connection contact areas, like the contact area 17 of the uppermost conductor layer 7, for example, may be laid bare. The remaining portions of the capping layer 6 are sufficiently large to cover the through-substrate vias 5 and to maintain the closure of the inner volumes 14.

Figure 4 shows a section of a cross-section according to Figure 3 after the dicing of the substrate into the individual device chips and after the bonding with a further substrate 2. Above the contact areas 17, the dielectric cover layer 8 has been removed, and contact pads 16 have been applied. The connection with the further electrically conductive structure 21 of the further substrate 2 has been effected by means of an interconnect 9 of electrically conductive material like a metal, especially a solder ball. The interspace between the substrates 1, 2 is filled with an underfill 23. The capping layer 6 prevents the underfill 23 from entering the inner volume 14 during the manufacturing process.

The device described above has the advantages that the capping layer 6 seals the through-substrate via 5, thus preventing ingress of undesirable materials later in the process flow. The capping layer 6 makes the product more robust for subsequent processing steps. The capping layer 6 may be used to planarize the surface of the wafer, potentially simplifying some of the later processing steps by eliminating a high topography on the wafer. The capping layer 6 avoids the need to fill the through-substrate via 5 completely with solid material and is consequently favorable in view of low cost, short processing time, and thermomechanical reliability. An air-filled through-substrate via is supposed to be an excellent construction from reliability perspective.

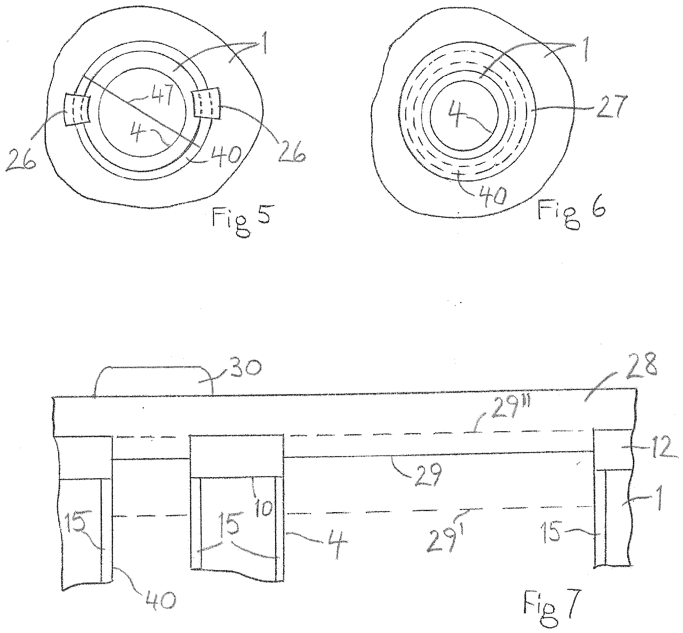

Figure 5 shows a section of a plan view onto a main surface of an embodiment of a semiconductor device according to the invention. The substrate 1 is provided with a hole 4 for a through-substrate via, which is cylindrical and surrounded by an annular cavity 40. The volume of the annular cavity 40 is a cylindrical barrel arranged coaxially with the hole 4, and the sidewalls of the annular cavity 40 are at least approximately two coaxial cylinders. The distances between the sidewalls of the annular cavity 40 and between the annular cavity 40 and the hole 4, measured in the direction of a diameter 47, may typically be between 5 µm and 20 µm. The diameter of the hole 4 may typically be in the range from 50 µm to 100 µm. Surrounding the through-substrate via by an annular cavity 40 decreases the capacitance of the via and prevents or at least reduces leakage currents. A capping layer forms two bridges 26 above the annular cavity 40. The number of such bridges 26 may vary. They may be used as a support for conductor tracks, for instance.

Figure 6 shows a section of a plan view onto a main surface of a further embodiment of the semiconductor device. The substrate 1 is provided with a hole 4 for a through-substrate via, which is surrounded by an annular cavity 40. The capping layer here forms an annular cover 27 closing the annular cavity 40 but not covering the hole 4 provided for the through-substrate via. The broken circles in Figure 6 indicate the upper edges of the sidewalls of the annular cavity 40 as hidden contours.

Figure 7 shows a section of a cross-section of an intermediate product of a method of production according to the invention. The substrate 1 is provided with the hole 4 and the surrounding annular cavity 40, of which only a section located on one side of the hole 4 is represented in Figure 7. The sidewalls of the openings 4, 40 may optionally be covered with sidewall insulations 15 formed by dielectric material, which may be an oxide of the semiconductor material, for example, as previously described. The main surface 10 of the substrate 1 is covered with intermetal dielectric 12, in which conductor tracks and vias of a wiring may be embedded. Above the main surface 10 a capping layer 28 is applied, which closes the hole 4 and the annular cavity 40. The capping layer 28 may be a dry film resist or a polyimide, for instance. If a dry film resist is used as the capping layer 28, it is preferably at least 14 µm thick. A hard bake step may be favorable to improve the mechanical stability of the resist. The lower surface 29 of the capping layer 28 may everywhere be located above the level of the main surface 10, but may have a slight depression within the openings of the hole 4 and the annular cavity 40. Instead, the lower surface 29' of the capping layer 28 may be located below the level of the main surface 10 within the openings, or the lower surface 29" of the capping layer 28 may be planar throughout. The position of the lower surface 29, 29', 29" within the openings depends on the manufacturing process and can be adapted to the requirements of individual embodiments. A mask 30, which may be a resist mask, for instance, is applied to the surface to enable a subsequent structuring of the capping layer 28.

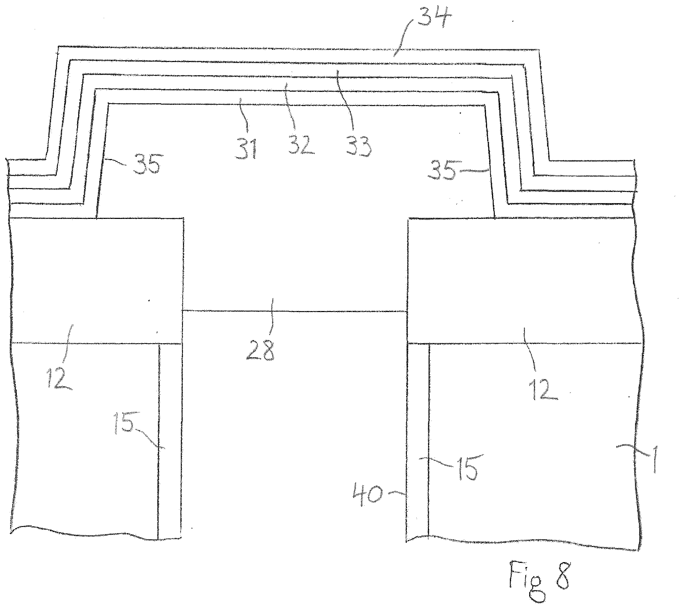

Figure 8 shows a detail of the cross-section according to Figure 7 after the structuring of the capping layer 28. The annular cavity 40 is now closed or at least bridged by a residual portion of the capping layer 28. The capping layer 28 thus forms a complete or partial cover on the annular cavity 40 and may be used as a support for conductor tracks, for instance. At least one dielectric layer may be arranged on the surface to insulate a conductive layer 34 from the capping layer 28 or other components located on the surface.

The sidewalls 35 of the residual capping layer 28 may be inclined as indicated in Figure 8. A control of the sidewall profile during processing may be advantageous, because a substantial slope may help to minimize corner stress for overlying layers. If a dry film resist is used for the capping layer 28, a favorably inclined slope of the sidewalls or a curvature of the sidewall profile rendering rounded corners may be generated by isotropic etching or ashing of the resist in order to reduce the thickness of the capping layer 28 and the sharpness of the upper edges. As the thickness of the capping layer 28 is reduced in this way, it may be preferable to have the lower surface 29' of the capping layer 28 located below the level of the main surface 10 within the openings of the hole 4 and the annular cavity 40, in order to keep the openings substantially and permanently plugged after an upper portion of the capping layer 28 has been removed.

In the embodiment according to Figure 8 a plurality of support layers 31, 32, 33 is applied before the conductive layer 34. One, several or all of the support layers 31, 32, 33 may also be provided as an insulation. The use of a sequence of layers is especially suitable to achieve a desired mechanical stability at elevated temperatures. If the capping layer 28 is a dry film resist, for example, which is mechanically stable up to a temperature T₁, a first support layer 31 may be deposited at a temperature well below T₁ without causing damage to the capping layer 28. The material of the first support layer 31 is preferably selected to be mechanically stable up to a temperature T₂>T₁, which means that the first support layer 31 tolerates higher temperatures than the dry film resist of the capping layer 28. A second support layer 32, which is selected to be mechanically stable up to a temperature T₃>T₂, is subsequently applied at a temperature below T₂, and a third support layer 33, which is selected to be mechanically stable up to a temperature T₄>T₃, is applied at a temperature below T₃. Each support layer 31, 32, 33 is thus deposited at a temperature that is tolerated at least by the immediately preceding support layer or preferably by several of the previously applied support layers. The number of support layers and their materials can be adapted to the embodiments. The thickness of the layer sequence has to be considered as well. The sequence of support layers allows to deposit each layer at a temperature that is tolerated at least by the preceding support layer, so that the structure as a whole remains mechanically stable, even if the dry film resist of the capping layer 28 is destroyed owing to the increase of the temperature during this process.

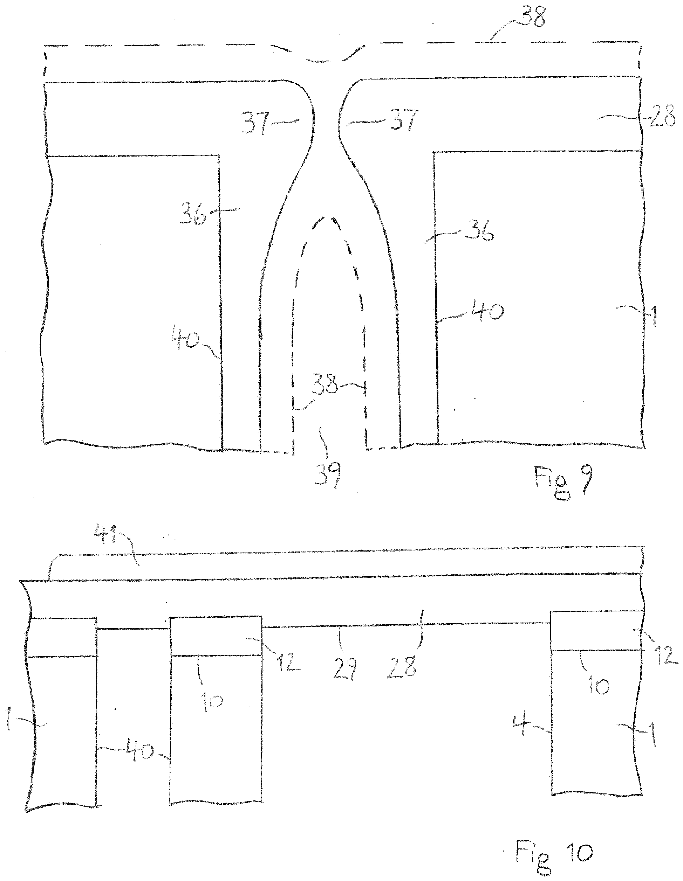

Figure 9 shows a detail of a cross-section at the opening of the annular cavity 40 for an alternative method of production. In this variant the annular cavity 40 is closed by the capping layer 28, which is formed using a non-conformal oxide deposition. The oxide layer 36 is applied to the surfaces in such a way that a bulge or bead 37 is formed at the edges. In the course of the growth of the oxide the surface 38 of the oxide layer 36 attains the position indicated by the broken lines, and the opening of the annular cavity 40 is closed. A void 39 is left inside the annular cavity 40.

Figure 10 shows a section of a cross-section of an intermediate product of a method of production for a further embodiment. The substrate 1 is provided with the hole 4 and the surrounding annular cavity 40, of which only a section located on one side of the hole 4 is represented as in Figure 7. The sidewalls of the openings 4, 40 may optionally be covered with sidewall insulations as previously described; this is not shown in conjunction with the embodiment according to Figure 10. The main surface 10 of the substrate 1 is covered with intermetal dielectric 12, in which conductor tracks and vias of a wiring may be embedded. Above the main surface 10 a capping layer 28 is applied, which may be a dry film resist or a polyimide, for instance. The capping layer 28 closes the hole 4 and the annular cavity 40. In this embodiment it is required that the lower surface 29 of the capping layer 28 be at least slightly depressed within the openings of the hole 4 and the annular cavity 40 as shown in Figure 10. The lower surface 29 of the capping layer 28 may be located even deeper in the openings, particularly below the level of the main surface 10, although this may not be a preferred embodiment. A mask 41, which may be a resist mask, for instance, is applied to enable a subsequent structuring of the capping layer 28.

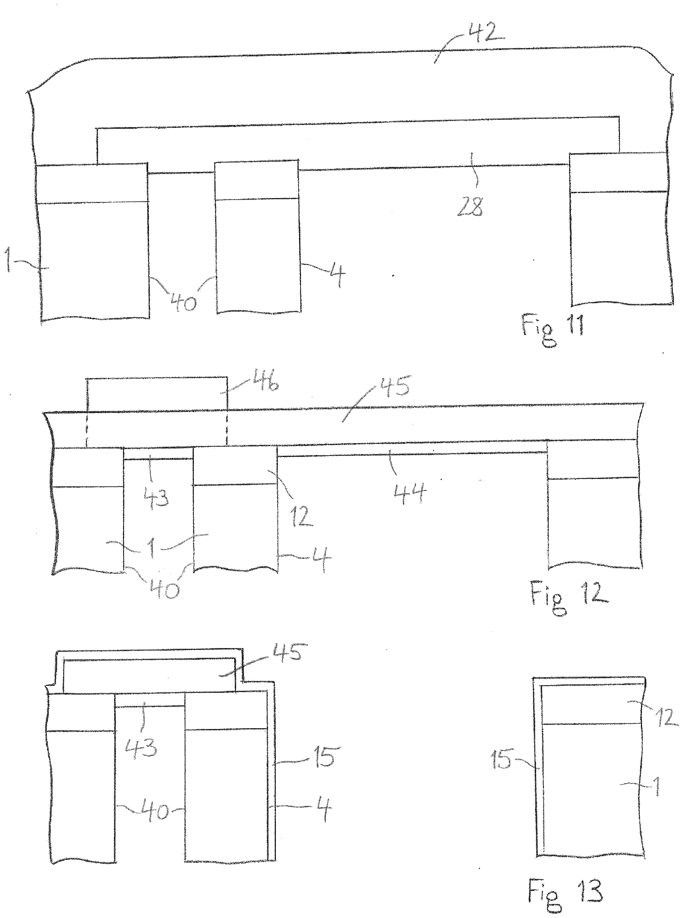

Figure 11 shows a cross-section according to Figure 10 after the structuring of the capping layer 28 and the application of a blanket layer 42, which may be an oxide. To avoid a damage of the capping layer 28, the deposition of the blanket layer 42 is preferably performed rapidly and at the lowest possible temperature. The blanket layer 42 is formed sufficiently thick, preferably at least 10 µm, to facilitate a subsequent backgrinding and polishing step.

Figure 12 shows a cross-section according to Figure 11 after the removal of the blanket layer 42 and the upper portion of the capping layer 28. For this purpose a CMP (chemical mechanical polishing) step may be applied, which removes the blanket layer 42 completely and the capping layer 28 except for a thin first membrane 43 closing the annular cavity 40 and a thin second membrane 44 closing the hole 4. It may be advantageous to make the first and second membranes 43, 44 as thin as possible, provided that their mechanical stability is sufficient. Then a further blanket layer 45, which may be an oxide or a nitride, is applied on the entire surface and planarized. Preferably the deposition of the further blanket layer 45 takes place at a temperature that is as low as possible. A mask 46 covering the area of the annular cavity 40 is applied for a subsequent structuring of the further blanket layer 45.

Figure 13 shows a cross-section according to Figure 12 after the structuring of the further blanket layer 45, which may be effected by a standard lithography step to form the mask 46 and a subsequent etching step using the mask 46. The second membrane 44 is removed as well, so that the hole 4 is reopened and the through-substrate via can be produced. A residual portion of the further blanket layer 45 remains above the annular cavity 40. Thus the first membrane 43 is reinforced and the annular cavity 40 is permanently closed. An insulating oxide may then be applied to form the sidewall insulation 15, and further process steps relating to the through-substrate via may follow in a way similar to the method steps already described above. With this variant of the production method initial topography steps of typically at least 14 µm, which are due to the application of the capping layer 28, may be reduced to dimensions of typically 1 µm or less.

### List of reference numerals

- 1: substrate
- 2: first further substrate
- 3: second further substrate
- 4: hole
- 5: through-substrate via
- 6: capping layer
- 7: conductor layer
- 8: covering layer
- 9: interconnect
- 10: main surface
- 11: electrically conductive structure
- 12: intermetal dielectric
- 13: area provided for an external electric connection
- 14: inner volume
- 15: sidewall insulation
- 16: contact pad
- 17: contact area
- 18: passivation
- 19: structured layer
- 20: sawing street
- 21: further electrically conductive structure
- 21': further electrically conductive structure
- 22: further intermetal dielectric
- 22': further intermetal dielectric
- 23: underfill
- 24: further underfill
- 25: contacting portion of the through-substrate via
- 26: bridge
- 27: annular cover
- 28: capping layer
- 29: lower surface of the capping layer
- 29': lower surface of the capping layer
- 29": lower surface of the capping layer
- 30: mask
- 31: first support layer
- 32: second support layer
- 33: third support layer
- 34: conductive layer
- 35: sidewall
- 36: oxide layer
- 37: bead
- 38: surface of the oxide layer
- 39: void
- 40: annular cavity
- 41: mask
- 42: blanket layer
- 43: first membrane
- 44: second membrane
- 45: further blanket layer
- 46: mask
- 47: diameter

## Claims

1. A method of producing a semiconductor device, comprising:
- a semiconductor substrate (1) having a main surface (10), the semiconductor substrate (1) being provided with an electrically conductive structure (11),
- forming a hole (4) through the substrate (1) in a direction normal to the main surface (10),
- forming an annular cavity (40) surrounding the hole (4), and
- forming a through-substrate via (5) in the hole (4) by introducing an electrically conductive material without filling the hole (4), thus leaving an open inner volume (14) of the through-substrate via (5), the through-substrate via (5) being electrically connected with the electrically conductive structure (11),
**characterized in that**
- a capping layer (28) is applied above the main surface (10), the capping layer (28) closing the annular cavity (40), and
- the capping layer (28) or a further capping layer (6) is applied as a permanent cover above the main surface (10) in such a way that the inner volume (14) is closed without filling it and that the electrically conductive structure (11) is not completely covered.

2. The method of claim 1, wherein
the capping layer (28) is applied and removed from the hole (4) before the through-substrate via (5) is formed, and the further capping layer (6) is applied after the through-substrate via (5) is formed, so that the further capping layer (6) covers the inner volume (14).

3. The method according to claim 1 or 2, further comprising:
- partially removing the capping layer (28) from the annular cavity (40), thus forming at least one bridge (26) across the annular cavity (40).

4. A semiconductor device comprising:
- a semiconductor substrate (1) having a main surface (10),
- an electrically conductive through-substrate via (5) in a direction normal to the main surface (10), and
- an inner volume (14) of the through-substrate via (5),
- an annular cavity (40) surrounding the through-substrate via (5), and
- a capping layer (6, 28) above the main surface (10) at least partially covering the annular cavity (40),
**characterized in that**
- the capping layer (6, 28) closes the inner volume (14) without filling it, thus forming a cover of the through-substrate via (5)

5. The semiconductor device according to claim 4, wherein the capping layer (6, 28) closes the annular cavity (40).

6. The semiconductor device according to claim 4, wherein the capping layer (6, 28) forms at least one bridge (26) across the annular cavity (40).

7. The semiconductor device according to one of claims 4 to 6, wherein the capping layer (6, 28) is a photoresist or a polyimide.

## Patentansprüche

1. Verfahren zum Herstellen eines Halbleiterbauelementes, Folgendes umfassend:
- ein Halbleitersubstrat (1) mit einer Hauptfläche (10), wobei das Halbleitersubstrat (1) mit einer elektrisch leitfähigen Struktur (11) versehen ist,
- Ausbilden einer Öffnung (4) durch das Substrat (1) in einer zur Hauptfläche (10) senkrechten Richtung,
- Ausbilden eines ringförmigen Hohlraums (40), der die Öffnung (4) umgibt, und
- Ausbilden einer Substratdurchkontaktierung (5) in der Öffnung (4), indem ein elektrisch leitfähiges Material, ohne die Öffnung (4) auszufüllen, eingebracht wird, wodurch ein offenes Innenvolumen (14) der Substratdurchkontaktierung (5) belassen wird, wobei die Substratdurchkontaktierung (5) elektrisch mit der elektrisch leitfähigen Struktur (11) verbunden ist,
**dadurch gekennzeichnet, dass**
- eine Deckschicht (28) über der Hauptfläche (10) aufgetragen wird, wobei die Deckschicht (28) den ringförmigen Hohlraum (40) schließt, und
- die Deckschicht (28) oder eine weitere Deckschicht (6) als Dauerabdeckung über der Hauptfläche (10) so aufgetragen wird, dass das Innenvolumen (14), ohne es auszufüllen, geschlossen wird und die elektrisch leitfähige Struktur (11) nicht vollständig abgedeckt wird.

2. Verfahren nach Anspruch 1, wobei
die Deckschicht (28) auf die Öffnung (4) aufgetragen und davon entfernt wird, bevor die Substratdurchkontaktierung (5) ausgebildet wird, und die weitere Deckschicht (6) aufgetragen wird, nachdem die Substratdurchkontaktierung (5) ausgebildet wurde, so dass die weitere Deckschicht (6) das Innenvolumen (14) abdeckt.

3. Verfahren nach Anspruch 1 oder 2, darüber hinaus umfassend:
- teilweises Entfernen der Deckschicht (28) vom ringförmigen Hohlraum (40), wodurch mindestens eine Brücke (26) über den ringförmigen Hohlraum (40) gebildet wird.

4. Halbleiterbauelement, Folgendes umfassend:
- ein Halbleitersubstrat (1) mit einer Hauptfläche (10),
- eine elektrisch leitfähige Substratdurchkontaktierung (5) in einer zur Hauptfläche (10) senkrechten Richtung, und
- ein Innenvolumen (14) der Substratdurchkontaktierung (5),
- einen ringförmigen Hohlraum (40), der die Substratdurchkontaktierung (5) umgibt, und
- eine Deckschicht (6, 28) über der Hauptfläche (10), die zumindest teilweise den ringförmigen Hohlraum (40) abdeckt,
**dadurch gekennzeichnet, dass**
- die Deckschicht (6, 28) das Innenvolumen (14) schließt, ohne es auszufüllen, wodurch eine Abdeckung der Substratdurchkontaktierung (5) gebildet ist.

5. Halbleiterbauelement nach Anspruch 4, wobei die Deckschicht (6, 28) den ringförmigen Hohlraum (40) schließt.

6. Halbleiterbauelement nach Anspruch 4, wobei die Deckschicht (6, 28) mindestens eine Brücke (26) über den Hohlraum (40) bildet.

7. Halbleiterbauelement nach einem der Ansprüche 4 bis 6, wobei es sich bei der Deckschicht (6, 28) um einen Fotolack oder ein Polyimid handelt.

## Revendications

1. Procédé de production d'un dispositif semiconducteur, comprenant:
- un substrat semiconducteur (1) présentant une surface principale (10), le substrat semiconducteur (1) étant doté d'une structure (11) électriquement conductrice,
- la formation d'un trou (4) à travers le substrat (1) dans direction perpendiculaire à la surface principale (10),
- la formation d'une cavité annulaire (40) entourant le trou (4), et
- la formation d'une interconnexion verticale de substrat (5) dans le trou (4) en introduisant un matériau électriquement conducteur sans remplir le trou (4), laissant ainsi un volume intérieur (14) ouvert de l'interconnexion verticale de substrat (5), l'interconnexion verticale de substrat (5) étant électriquement connectée à la structure (11) électriquement conductrice,
**caractérisé en ce que**
- une couche de recouvrement (28) est appliquée au-dessus de la surface principale (10), la couche de recouvrement (28) fermant la cavité annulaire (40), et
- la couche de recouvrement (28) ou une couche de recouvrement (6) supplémentaire est appliquée comme couverture permanente au-dessus de la surface principale (10) de telle façon que le volume intérieur (14) soit fermé sans le remplir et que la structure (11) électriquement conductrice ne soit pas entièrement recouverte.

2. Le procédé de la revendication 1, sachant que
la couche de recouvrement (28) est appliquée et enlevée du trou (4) avant que l'interconnexion verticale de substrat (5) soit formée, et la couche de recouvrement (6) supplémentaire est appliquée après que l'interconnexion verticale de substrat (5) est formée, de sorte que la couche de recouvrement (6) supplémentaire recouvre le volume intérieur (14).

3. Le procédé selon la revendication 1 ou 2, comprenant en outre:
- l'enlèvement partiel de la couche de recouvrement (28) de la cavité annulaire (40), formant ainsi au moins un pont (26) par-dessus la cavité annulaire (40).

4. Dispositif semiconducteur comprenant:
- un substrat semiconducteur (1) présentant une surface principale (10),
- une interconnexion verticale de substrat (5) électriquement conductrice dans une direction perpendiculaire à la surface principale (10), et
- un volume intérieur (14) de l'interconnexion verticale de substrat (5),
- une cavité annulaire (40) entourant l'interconnexion verticale de substrat (5), et
- une couche de recouvrement (6, 28) au-dessus de la surface principale (10), recouvrant au moins en partie la cavité annulaire (40),
**caractérisé en ce que**
- la couche de recouvrement (6, 28) ferme le volume intérieur (14) sans le remplir, formant ainsi une couverture de l'interconnexion verticale de substrat (5).

5. Le dispositif semiconducteur selon la revendication 4, sachant que la couche de recouvrement (6, 28) ferme la cavité annulaire (40).

6. Le dispositif semiconducteur selon la revendication 4, sachant que la couche de recouvrement (6, 28) forme au moins un pont (26) par-dessus la cavité annulaire (40).

7. Le dispositif semiconducteur selon l'une des revendications 4 à 6, sachant que la couche de recouvrement (6, 28) est une résine photosensible ou un polyimide.
